# EUROPEAN PATENT APPLICATION

(11) **EP 4 321 929 A1**
(43) Date of publication of application: **14.02.2024**
(21) Application number: 22855253.5
(22) Date of filing: 28.07.2022
(51) Int. Cl.: G03F 1/20

(54) **RETICLE PREPARATION METHOD, RETICLE, JOSEPHSON JUNCTION ELEMENT, AND QUANTUM CHIP**

(30) Priority: 13.08.2021 CN 202110930147
(71) Applicant: Origin Quantum Computing Technology (Hefei) Co., Ltd, Hefei, Anhui 230088 (CN)
(72) Inventor: ZHAO, Yongjie, Hefei, Anhui 230088 (CN); YANG, Hui, Hefei, Anhui 230088 (CN); DAI, Zhipeng, Hefei, Anhui 230088 (CN); MA, Liangliang, Hefei, Anhui 230088 (CN); YOU, Bing, Hefei, Anhui 230088 (CN); WANG, Nianci, Hefei, Anhui 230088 (CN); LU, Rui, Hefei, Anhui 230088 (CN)
(74) Representative: v. Bezold & Partner Patentanwälte - PartG mbB
(86) International application number: PCT/CN2022/108618
(87) International publication number: WO 2023/016270

(57) **Abstract**

A mask fabrication method, mask, Josephson junction element, and quantum chip is provided, which belong to the field of quantum information, especially the field of quantum computing. The mask fabrication method includes: providing a dielectric layer, wherein a ratio of a thickness of the dielectric layer to a line width of a target pattern to be fabricated is greater than a cutting depth-to-width ratio allowed by a patterning apparatus; determining a first sublayer and a second sublayer of the dielectric layer, wherein a ratio of a thickness of the second sublayer to the line width of the target pattern is less than or equal to the cutting depth-to-width ratio; forming the target pattern on the second sublayer and a first pattern on the first sublayer, wherein the first pattern exposes the target pattern. The present application is capable of fabricating a mask containing the target pattern when the ratio of the provided dielectric layer thickness to the line width of the target pattern to be fabricated is greater than the cutting depth-to-width ratio allowed by the patterning apparatus.

## Description

The present application claims the priority to a Chinese patent application No. 202110930147.0 filed with the China National Intellectual Property Administration on August 13, 2021 and entitled "MASK FABRICATION METHOD, MASK, JOSEPHSON JUNCTION ELEMENT AND QUANTUM CHIP", which is incorporated herein by reference in its entirety.

### Technical field

The present application belongs to the field of quantum information, in particular to the field of quantum computing, and specially, the present application relates to a mask fabrication method, a mask, a Josephson junction element and a quantum chip.

### Background

Quantum computers are a class of physical devices that follow the laws of quantum mechanics to perform high-speed mathematical and logical operations, store and process quantum information. The characteristics of the quantum computers mainly include a fast operation speed, strong information processing ability, and a wide range of applications. Compared with general computers, the more information is processed, the more favorable it is for quantum computers to perform operations, and the more accurate the operations can be ensured.

Quantum chips are core components of the quantum computers, processes of fabricating the quantum chips mainly include the photolithography and the masking method. The photolithography method is limited by the exposure accuracy, which can lead to an unstable pattern line width. When processing micro-components in the quantum chip, any trivial change in size may affects performance parameters of the quantum chip. The masking method can overcome the instability of the pattern line width. However, when a ratio of a thickness of a provided dielectric layer to a line width of a target pattern to be fabricated is greater than a cutting depth-to-width ratio allowed by a patterning apparatus, it is difficult to fabricate a mask containing the target pattern by the masking method.

### Summary

It is an object of the present application to provide a mask fabrication method, a mask, a Josephson junction element and a quantum chip to overcome the deficiencies in the prior art, which is capable of fabricating a mask containing the target pattern to be fabricated when the ratio of the thickness of the provided dielectric layer to the line width of the target pattern is greater than the cutting depth-to-width ratio allowed by the patterning apparatus.

In a first aspect, an embodiment of the present application provides a mask fabrication method, including:
providing a dielectric layer, a ratio of a thickness of the dielectric layer to a line width of a target pattern to be fabricated is greater than a cutting depth-to-width ratio allowed by a patterning apparatus;
determining a first sublayer and a second sublayer of the dielectric layer, wherein a ratio of a thickness of the second sublayer to the line width of the target pattern is less than or equal to the cutting depth-to-width ratio;
forming the target pattern on the second sublayer and a first pattern on the first sublayer, wherein the first pattern exposes the target pattern.

Optionally, the determining a first sublayer and a second sublayer of the dielectric layer includes:
if the ratio of the thickness of the dielectric layer to the line width of the target pattern is greater than or equal to a preset threshold, determining at least two first sublayers and one second sublayer;
if the ratio of the thickness of the dielectric layer to the line width of the target pattern is less than the preset threshold, determining one first sublayer and one second sublayer.

Optionally, before the forming the target pattern on the second sublayer, the method further includes:
forming a marker on the dielectric layer for positioning cutting, and determining, based on the marker, a first target area on the first sublayer for forming the first pattern and a second target area on the second sublayer for forming the target pattern.

Optionally, the forming the target pattern on the second sublayer and a first pattern on the first sublayer includes:
using the patterning apparatus to cut the first target area in a direction of a thickness of the first sublayer to form the first pattern on the first sublayer; and to cut the second target area in a direction of a thickness of the second sublayer to form the target pattern on the second sublayer.

Optionally, the providing a dielectric layer includes:
providing a semiconductor device, which includes the dielectric layer, a substrate, and an insulating layer formed between the substrate and the dielectric layer.

Optionally, the substrate is a silicon substrate, the dielectric layer is a silicon dielectric layer, and the insulating layer is a silicon dioxide insulating layer.

Optionally, thicknesses of the insulating layer, the dielectric layer, and the substrate increase sequentially.

Optionally, the preset threshold is 5.

Optionally, the patterning apparatus is a focused ion beam FIB apparatus, and the cutting depth-to-width ratio is 1:1.

In a second aspect, an embodiment of the present application provides a method for fabricating a Josephson junction element, including: fabricating the Josephson junction element by using the mask fabricated according to any method of the first aspect, wherein the line width of the target pattern is between 150 nm and 250 nm.

In a third aspect, an embodiment of the present application provides a mask including a dielectric layer having a first sublayer and a second sublayer, wherein a ratio of a thickness of the dielectric layer to a line width of a target pattern to be fabricated is greater than a cutting depth-to-width ratio allowed by a patterning apparatus, a first pattern is formed on the first sublayer, a target pattern is formed on the second sublayer and the first pattern exposes the target pattern, wherein a ratio of a thickness of the second sublayer to the line width of the target pattern is less than or equal to the cutting depth-to-width ratio.

Optionally, if the ratio of the thickness of the dielectric layer to the line width of the target pattern is greater than or equal to a preset threshold, the number of first sublayers is greater than or equal to 2; if the ratio of the thickness of the dielectric layer to the line width of the target pattern is less than the preset threshold, the number of first sublayers is 1.

Optionally, the dielectric layer is further formed with a marker for positioning cutting, and the marker is configured to determine a first target area on the first sublayer for forming the first pattern and a second target area on the second sublayer for forming the target pattern.

Optionally, the first pattern is formed by using the patterning apparatus to cut the first target area in a direction of a thickness of the first sublayer; and the target pattern is formed by using the patterning apparatus to cut the second target area in a direction of the thickness of the second sublayer.

Optionally, the mask further includes a substrate and an insulating layer formed between the substrate and the dielectric layer.

Optionally, the substrate is a silicon substrate, the dielectric layer is a silicon dielectric layer, and the insulating layer is a silicon dioxide insulating layer.

Optionally, thicknesses of the insulating layer, the dielectric layer, and the substrate increase sequentially.

Optionally, the preset threshold is 5.

Optionally, the patterning apparatus is a focused ion beam apparatus, and the cutting depth-to-width ratio is 1:1.

In a forth aspect, an embodiment of the present application provides a Josephson junction element fabricated by masking based on any mask of the third aspect, wherein the line width of the target pattern is between 150 nm and 250 nm.

In a fifth aspect, an embodiment of the present application provides a superconducting quantum chip including the Josephson junction element of the fourth aspect.

Compared with the prior art, in the case where the ratio of the thickness of the provided dielectric layer to the line width of the target pattern to be fabricated is greater than the cutting depth-to-width ratio allowed by the patterning apparatus, the present application firstly determines the first sublayer and second sublayer of the dielectric layer, wherein the ratio of the thickness of the second sublayer to the line width of the target pattern is less than or equal to the cutting depth-to-width ratio; and then forms the target pattern on the second sublayer and a first pattern on the first sublayer, wherein the first pattern exposes the target pattern. When the ratio of the thickness of the provided dielectric layer to the line width of the target pattern to be fabricated is greater than the cutting depth-to-width ratio allowed by the patterning apparatus, the present application realizes the fabrication of the target pattern by means of layering, and finally forms the dielectric layer with the target pattern, wherein the dielectric layer can be used in the fabrication of the components in the quantum chip by masking, and therefore it is also beneficial to the control of the line width of the target pattern.

### Brief Description of the Drawings

In order to more clearly describe the technical solutions of the embodiments of the present application and the prior art, accompanying drawings that need to be used in the embodiments and the prior art will be briefly described below. Obviously, the drawings described below are only some of the embodiments of the present application. Those skilled in the art may also obtain other accompanying drawings based on these accompanying drawings without any creative efforts.
FIG 1 shows a schematic flow chart of a mask fabrication method provided by an embodiment of the present application;
FIG 2 shows a schematic cross-sectional view of a dielectric layer provided by an embodiment of the present application;
FIG 3 shows a schematic cross-sectional view of another dielectric layer provided by an embodiment of the present application;
FIG 4 shows a schematic cross-sectional view of a semiconductor device provided by an embodiment of the present application;
FIG 5 shows a top view of another semiconductor device provided by an embodiment of the present application.

Description of the reference signs: 1-dielectric layer, 2-insulating layer, 3-substrate, 11-first sublayer, 12-second sublayer, 13-marker, 111-first target area, 121-second target area.

### Detailed Description

In order to make the purposes, technical solutions and advantages of the embodiments of the present application clearer, embodiments of the present application will be described in detail below in connection with the accompanying drawings. However, an ordinary skilled in the art can understand that, in each embodiment of the present application, a number of technical details have been proposed for the purpose of enabling the reader to better understand the present application. However, even without these technical details and various variations and modifications based on the following embodiments, the technical solution claimed by the present application can be realized. The embodiments are divided in the following for the convenience of description, and shall not constitute any limitation on the specific implementation of the present application, and each embodiment can be combined with each other and refer to each other under the premise of not contradicting each other.

It is to be noted that the terms "comprising" and "having", and any variations thereof, in the description and claims of the present application and in the drawings, are intended to cover non-exclusive including, e.g., a process, method, system, product or device comprising a series of steps or units need not be limited to those steps or units that are clearly listed, but may include other steps or units that are not clearly listed or that are inherent to the process, method, product or apparatus.

In addition, it should be understood that when a layer (or mold), area, pattern or structure is referred to as being "on" a substrate, layer (or mold), area and/or pattern, the layer (or mold), area, pattern or structure may be located directly on another layer or substrate, and/or an insertion layer may also be present therebetween. In addition, it should be understood that when a layer is referred to as being "under" another layer, the layer may be located directly under the other layer, and/or one or more insertion layers may also be present therebetween. In addition, references to being "on" and "under" each layer may be made based on the drawings.

Quantum computing is a field that is increasingly being widely noticed and studied at home and abroad at present, and the Josephson junction-based superconducting quantum bit system is considered to be one of the most promising systems for realizing quantum computing due to its advantages such as good scalability and high fidelity of gate operation. A superconducting qubit, as a key component of a superconducting quantum chip, is a qubit based on a Josephson junction circuit, the main part of which is a superconducting circuit containing one or more Josephson junctions. The Josephson junction generally consists of two layers of superconductors and an extremely thin insulator sandwiched between the two layers of superconductors, and a significant electron pair tunneling effect, known as the Josephson effect, occurs when a thickness of the insulating layer is as thin as a few nanometers.

The relevant superconducting quantum chip fabrication process is specified as follows: first, a pattern structure, such as a superconducting metal layer, a ground layer and a ground capacitor, is formed on a substrate, and a fabrication area for fabricating a Josephson junction is exposed between the ground layer and the ground capacitor; and then, a process related to fabricating the Josephson junction is carried out on the fabrication area, e.g., a photoresist is coated on the substrate, and a mask pattern with a window is formed after exposure and development, then evaporation, oxidation, and re-evaporation are performed on the exposed area on the substrate by using the mask pattern, to fabricate and obtain the Josephson junction that is electrically connected to the ground capacitor, the ground layer.

The Josephson junction in a qubit device is a small-sized structure, the size of which is generally from one hundred nanometers to two hundred nanometers, and small changes in the size may affect performance parameters of the Josephson junction, which in turn affects performance parameters of the qubit device. For the fabrication of the Josephson junction in the qubit device, if the traditional lithography, development, and coating processes are used, the linewidth is unstable due to the exposure accuracy, etc. Therefore, it is necessary to develop a technology that utilizes the Focused Ion Beam (FIB) cutting technology and the (Silicon On Insulator) mask including the target pattern, to fabricate a Josephson junction with a small linewidth on the substrate, and to fabricate, using the masking instead of the photolithography process, the desired Josephson junction directly on the surface by evaporating. Due to the limitation of the cutting depth-to-width ratio of FIB, which is generally 1:1, it is difficult for this process to fabricate an aperture with a width of 200 nm and a depth of 1 µm (with a depth-to-width ratio of 5:1) on a 1 µm or even thicker SOI (Silicon-On-Insulator) mask. Therefore, it is a technical problem that needs to be solved urgently that how to fabricate a mask containing a target pattern in the case where the ratio of the thickness of the provided dielectric layer to the line width of the target pattern to be fabricated is greater than the cutting depth-to-width ratio allowed by the patterning apparatus.

Based on the above background art and technical problem, the present application proposes the following solution.

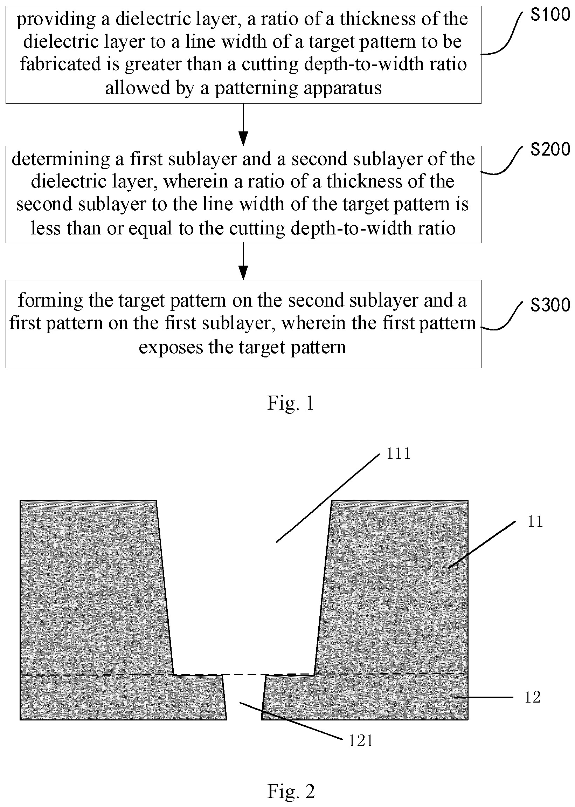

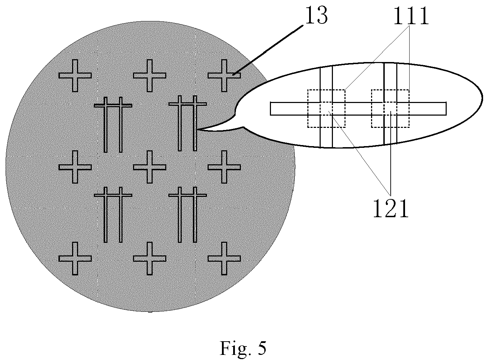

Referring to FIG 1-FIG 5, in a first aspect, an embodiment of the present application provides a mask fabrication method including step S100 to step S300, wherein:
S 100, providing a dielectric layer 1, a ratio of a thickness of the dielectric layer 1 to a line width of a target pattern to be fabricated is greater than a cutting depth-to-width ratio allowed by a patterning apparatus. The dielectric layer 1 may be one of a silicon dielectric layer, a sapphire dielectric layer, a silicon carbide dielectric layer, or other dielectric layers; the patterning apparatus may be one of a focused ion beam (FIB) apparatus, an electron beam apparatus, a helium-neon ion microscope, a UV exposure apparatus, or other patterning apparatuses, which is not limited herein. The cutting depth-to-width ratio is determined by the characteristics of the patterning apparatus itself.
S200, determining a first sublayer 11 and a second sublayer 12 of the dielectric layer 1, wherein a ratio of thicknesses of the first sublayer 11 to the line width of the target pattern and a ratio of thicknesses of the second sublayer 12 to the line width of the target pattern each is less than or equal to the cutting depth-to-width ratio. The number of first sublayers 11, the number of second sublayers 12 may be one or more, which is not limited herein. By setting the ratio of thickness of the first sublayer 11 to the line width of the target pattern and the ratio of thickness of the second sublayer 11 to the line width of the target pattern both to be less than or equal to the cutting depth-to-width ratio, the patterning apparatus can subsequently cut the first sublayer and the second sublayer with satisfying the limitation of its cutting depth-to-width ratio.
S300, forming the target pattern on the second sublayer 12 and a first pattern on the first sublayer 11, wherein the first pattern exposes the target pattern. The target pattern on the second sublayer 12 can be formed first, and then the first pattern is formed on the first sublayer 11, wherein the first pattern exposes the target pattern and does not block the target pattern, thus not affecting the subsequent fabrication of a component through the mask; or the first pattern on the first sublayer 11 can be formed first, with the first pattern exposing a portion of the second sublayer 12, and then the target pattern is formed on the exposed portion of the second sublayer 12, such that the first pattern exposes the target pattern. The first pattern exposing the portion of the second sublayer 12 facilitates the formation of the target pattern on the second sublayer 12, and the first pattern exposing the target pattern reduces block to the target pattern, facilitating the subsequent fabrication of a component through the mask.

Compared with the prior art, in the case where the ratio of the thickness of the provided dielectric layer 1 to the line width of the target pattern to be fabricated is greater than the cutting depth-to-width ratio allowed by the patterning apparatus, the present application firstly determines the first sublayer 11 and second sublayer 12 of the dielectric layer 1, wherein the ratio of the thickness of the second sublayer 12 to the line width of the target pattern is less than or equal to the cutting depth-to-width ratio; and then forms the target pattern on the second sublayer 12 and a first pattern on the first sublayer 11, wherein the first pattern exposes the target pattern. When the ratio of the thickness of the provided dielectric layer to the line width of the target pattern to be fabricated is greater than the cutting depth-to-width ratio allowed by the patterning apparatus, the present application realizes the fabrication of the target pattern by means of layering, and finally forms the dielectric layer with the target pattern, wherein the dielectric layer can be used in the fabrication of the components in the quantum chip by masking, and therefore it is also beneficial to the control of the line width of the target pattern.

In an embodiment of the present application, the determining the first sublayer 11 and second sublayer 12 of the dielectric layer in step S200 includes: determining at least two first sublayers 11 and one second sublayer 12 if the ratio of the thickness of the dielectric layer 1 to the line width of the target pattern is greater than or equal to a preset threshold; determining one first sublayer 11 and one second sublayer 12 if the ratio of the thickness of the dielectric layer 1 to the line width of the target pattern is less than the preset threshold.

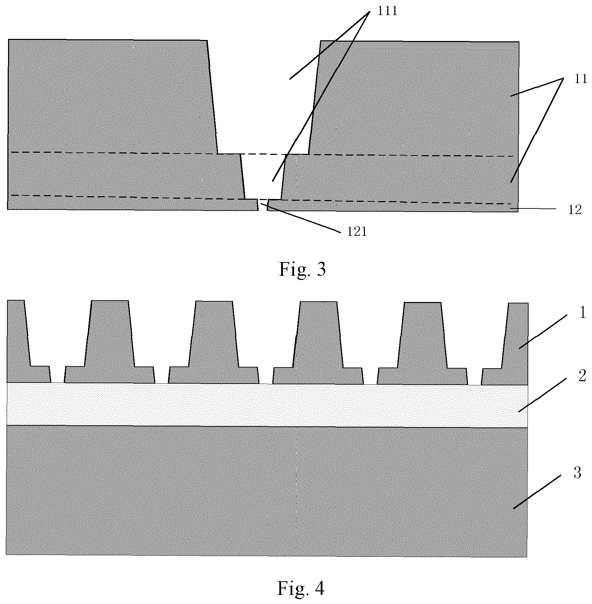

The preset threshold is determined based on the material, shape and the like of the dielectric layer 1, and may be 1, 5, 10, 15 or other values. When the ratio of the thickness of the dielectric layer 1 to the line width of the target pattern is greater than or equal to the preset threshold, if only one first sublayer 11 is provided, the first pattern needs to have a larger width to ensure the accuracy of cutting of the target pattern. Because after the first pattern is formed, both sides of the first sublayer 11 are too weak, the dielectric layer 1 is easy to crack, which is not conducive to maintaining the stability of the dielectric layer 1. Therefore, when the ratio of the thickness of the dielectric layer 1 to the line width of the target pattern is greater than or equal to the preset threshold, the dielectric layer 1 needs to be divided into a plurality of layers to form at least two first sublayers 11 and one second sublayer 12. In one example, the width of the first pattern in each first sublayer 11 is gradually increased as moving away from the second sublayer 12, so that, on the basis of guaranteeing an accuracy of cutting of the target pattern, the thickness on both sides of the first sublayer 11 is increased and the stability of the dielectric layer 1 is improved. For example, as shown in FIG 3, two first sublayers 11 are included in FIG 3, wherein the width of the first pattern in a first sublayer 11 closer to the second sublayer 12 is less than the width of the first pattern in another first sublayer 11.

When the ratio of the thickness of the dielectric layer 1 to the line width of the target pattern is less than the preset threshold, in order to reduce the number of subsequent cuts and to increase the speed of the process flow, forming one first sublayer 11 and one second sublayer 12 is sufficient to maintain the stability of the dielectric layer 1.

In an embodiment of the present application, before the forming the target pattern on the second sublayer 12 in step S300, the method further includes: forming a marker 13 on the dielectric layer 1 for positioning cutting and determining, based on the marker 13, a first target area 111 on the first sublayer 11 for forming the first pattern and a second target area 121 on the second sublayer 12 for forming the target pattern.

The shape of the marker 13 may be a cross, a triangle, a circle, or other shapes, and the number of markers 13 may be one, two, or more; the shape of the first target area 111 is the same as the first pattern, and the shape of the second target area 121 is the same as the target pattern.

In this embodiment, by forming the mark 13 on the dielectric layer 1 for positioning cutting and determining, based on the marker 13, the first target area 111 on the first sublayer 11 for forming the first pattern and the second target area 121 on the second sublayer 12 for forming the target pattern, accurate positioning cutting is facilitated and errors are reduced.

In an embodiment of the present application, the forming the target pattern on the second sublayer 12 and a first pattern on the first sublayer 11 in step S300, includes: using the patterning apparatus to cut the first target area 111 in a direction of a thickness of the first sublayer 11 to form the first pattern on the first sublayer 11; and to cut the second target area 121 in a direction of a thickness of the second sublayer 12 to form the target pattern on the second sublayer 12.

In an embodiment of the present application, the providing a dielectric layer 1 in step S 100, includes:
providing a semiconductor device, which includes the dielectric layer 1, a substrate 3 and an insulating layer 2 formed between the substrate 3 and the dielectric layer 1.

The insulating layer 2 on the substrate 3 can be physically or chemically formed. The physical formation may be, for example, directly adding a layer of material with an insulating property on the surface of the substrate 3, such as directly adhering a layer of silicon carbide or silicon dioxide. The chemical formation may be, for example, forming the insulating layer 2 on the surface of the substrate 3 by oxidization, wherein the oxidization includes at least one of the following: natural oxidization, dry oxidization, wet oxidization.

The semiconductor device provided by the embodiment of the present application is a three-layer structure consisting of the substrate 3, the insulating layer 2, and the dielectric layer 1. In fabricating a mask through the semiconductor device, the presence of the intermediate insulating layer 2 facilitates the control of an etching rate among different layers and the semiconductor device will not be completely etched through, which reduces the damage to the device and increases the yield rate.

In an embodiment of the present application, the substrate 3 is a silicon substrate, the dielectric layer 1 is a silicon dielectric layer, and the insulating layer 2 is a silicon dioxide insulating layer. The silicon dioxide is selected as the insulating layer because the etching rate of silicon dioxide is easy to be precisely controlled, thus reducing the mis-etching of the substrate 3 or the dielectric layer 1. In the actual etching process, when the dielectric layer 1 or the substrate 3 is etched, it will generally be etched a little deeper to reach the silicon dioxide insulating layer 2, to prevent insufficient etching; and the same etching can be applied when the silicon dioxide layer is etched, which can be controlled by controlling the etching rate, or can be controlled by selecting different etching gases, wherein the gases can selectively etch the silicon dioxide without etching the silicon.

In an embodiment of the present application, the thicknesses of the insulating layer 2, the dielectric layer 1 and the substrate 3 increase sequentially. The thickness of the insulating layer 2 is 100 nm-1000 nm, the thickness of the dielectric layer 1 is 3 µm-10 µm, and the thickness of the substrate 3 is 100 µm-700 µm, and the semiconductor device configured in this manner is easy to produce.

In an embodiment of the present application, the preset threshold is 5. In the actual fabrication process, for fabricating the Josephson junction element through a target pattern of 200 nm×200 nm on the dielectric layer 1 of 1 µm or less, a two-time cutting method is generally adopted; for fabricating the Josephson junction element through a target pattern of 200 nm×200 nm on the dielectric layer 1 of above 1 µm, a multiple-time cutting method is generally adopted, where the multiple-time means three or more times. In the case where the patterning apparatus is a FIB apparatus and the dielectric layer 1 is a silicon dielectric layer, when the ratio of the thickness of the dielectric layer 1 to the line width of the target pattern is greater than or equal to 5, the first patterning needs to have a larger width if only one first sublayer 11 is provided, so as to ensure the accuracy of the cutting of the target pattern, and after the first pattern is formed, both sides of the first sublayer 11 are too weak, resulting in that the dielectric layer 1 is easy to crack, which is not conducive to maintaining the stability of the dielectric layer 1. When the ratio of the thickness of the dielectric layer 1 to the line width of the target pattern is less than 5, even if only one first sublayer 11 is provided, the dielectric layer 1 has higher stability and the number of subsequent cutting is reduced, thus improving the speed of the process flow.

In an embodiment of the present application, the patterning apparatus is a FIB apparatus, and the cutting depth-to-width ratio is 1: 1. FIB utilizes a high-intensity focused ion beam to nano-process materials, and in conjunction with real-time observation by a high magnification electron microscope such as a scanning electron microscope (SEM), has become a major method for nanoscale analysis and fabrication. It has been widely used in semiconductor integrated circuit modification, ion implantation, cutting and failure analysis. It has an advantage of ultra-high cutting precision in ion beam etching.

In a second aspect, an embodiment of the present application provides a method for fabricating a Josephson junction element, including: fabricating the Josephson junction element by using the mask fabricated according to any method described in the first aspect, wherein the line width of the target pattern is 150 nm-250 nm.

In a third aspect, an embodiment of the present application provides a mask including a dielectric layer 1 having a first sublayer 11 and a second sublayer 12, wherein a ratio of a thickness of the dielectric layer 1 to a line width of a target pattern to be fabricated is greater than a cutting depth-to-width ratio allowed by a patterning apparatus, a first pattern is formed on the first sublayer 11, a target pattern is formed on the second sublayer 12 and the first pattern exposes the target pattern, wherein a ratio of a thickness of the second sublayer 12 to the line width of the target pattern is less than or equal to the cutting depth-to-width ratio.

Optionally, if the ratio of the thickness of the dielectric layer 1 to the line width of the target pattern is greater than or equal to a preset threshold, the number of first sublayers 11 is greater than or equal to 2; if the ratio of the thickness of the dielectric layer 1 to the line width of the target pattern is less than the preset threshold, the number of first sublayers 11 is 1.

Optionally, the dielectric layer 1 is further formed with a marker 13 for positioning cutting, and the marker 13 is configured to determine a first target area 111 on the first sublayer 11 for forming the first pattern and a second target area 121 on the second sublayer 12 for forming the target pattern.

Optionally, the first pattern is formed by using the patterning apparatus to cut the first target area 111 in a direction of a thickness of the first sublayer 11; and the target pattern is formed by using the patterning apparatus to cut the second target area 121 in a direction of the thickness of the second sublayer 12.

Optionally, the mask further includes a substrate 3 and an insulating layer 2 formed between the substrate 3 and the dielectric layer 1.

Optionally, the substrate 3 is a silicon substrate, the dielectric layer 1 is a silicon dielectric layer, and the insulating layer 2 is a silicon dioxide insulating layer.

Optionally, the thickness of the insulating layer 2, the dielectric layer 1, and the substrate 3 increases sequentially.

Optionally, the preset threshold is 5.

Optionally, the patterning apparatus is a focused ion beam apparatus and the cutting depth-to-width ratio is 1:1.

In a fourth aspect, an embodiment of the present application provides a Josephson junction element fabricated by masking based on any mask in the third aspect, wherein the line width of the target pattern is 150 nm-250 nm.

In a fifth aspect, an embodiment of the present application provides a superconducting quantum chip including the Josephson junction element in the fourth aspect.

It should be noted that the specific implementations of the second aspect, the third aspect, the fourth aspect and the fifth aspect can be referred to above specific implementations of the method embodiments of the first aspect and will not be repeated here.

The above embodiments according to the drawings describe the configuration, features and effects of the present application in detail, and are only the better embodiments of the present application, but the present application does not limit the scope of implementation with those as shown in the drawings. Any changes or modifications made in accordance with the concept of the present application are equivalent embodiments of equivalent changes, and does not exceed the spirit covered by the description and drawings, and shall be within the scope of protection of the present application.

## Claims

1. A mask fabrication method, comprising:
providing a dielectric layer, a ratio of a thickness of the dielectric layer to a line width of a target pattern to be fabricated is greater than a cutting depth-to-width ratio allowed by a patterning apparatus;
determining a first sublayer and a second sublayer of the dielectric layer, wherein a ratio of a thickness of the second sublayer to the line width of the target pattern is less than or equal to the cutting depth-to-width ratio;
forming the target pattern on the second sublayer and a first pattern on the first sublayer, wherein the first pattern exposes the target pattern.

2. The method according to claim 1, wherein the determining a first sublayer and a second sublayer of the dielectric layer comprises:
if the ratio of the thickness of the dielectric layer to the line width of the target pattern is greater than or equal to a preset threshold, determining at least two first sublayers and one second sublayer;
if the ratio of the thickness of the dielectric layer to the line width of the target pattern is less than the preset threshold, determining one first sublayer and one second sublayer.

3. The method according to claim 2, wherein, before the forming the target pattern on the second sublayer, the method further comprises:
forming a marker on the dielectric layer for positioning cutting, and determining, based on the marker, a first target area on the first sublayer for forming the first pattern and a second target area on the second sublayer for forming the target pattern.

4. The method according to claim 3, wherein the forming the target pattern on the second sublayer and a first pattern on the first sublayer comprises:
using the patterning apparatus to cut the first target area in a direction of a thickness of the first sublayer to form the first pattern on the first sublayer; and to cut the second target area in a direction of a thickness of the second sublayer to form the target pattern on the second sublayer.

5. The method according to any one of claims 1-4, wherein the providing a dielectric layer comprises:
providing a semiconductor device, which comprises the dielectric layer, a substrate, and an insulating layer formed between the substrate and the dielectric layer.

6. The method according to claim 5, wherein the substrate is a silicon substrate, the dielectric layer is a silicon dielectric layer, and the insulating layer is a silicon dioxide insulating layer.

7. The method according to claim 5, wherein thicknesses of the insulating layer, the dielectric layer, and the substrate increase sequentially.

8. The method according to claim 2, wherein the preset threshold is 5.

9. The method according to claim 8, wherein the patterning apparatus is a focused ion beam FIB apparatus, and the cutting depth-to-width ratio is 1:1.

10. A method for fabricating a Josephson junction element, comprising: fabricating the Josephson junction element by using the mask fabricated according to the method of any one of claims 1-9, wherein the line width of the target pattern is between 150 nm and 250 nm.

11. A mask comprising a dielectric layer having a first sublayer and a second sublayer, wherein a ratio of a thickness of the dielectric layer to a line width of a target pattern to be fabricated is greater than a cutting depth-to-width ratio allowed by a patterning apparatus, a first pattern is formed on the first sublayer, a target pattern is formed on the second sublayer and the first pattern exposes the target pattern, wherein a ratio of a thickness of the second sublayer to the line width of the target pattern is less than or equal to the cutting depth-to-width ratio.

12. The mask according to claim 11, wherein if the ratio of the thickness of the dielectric layer to the line width of the target pattern is greater than or equal to a preset threshold, the number of first sublayers is greater than or equal to 2; if the ratio of the thickness of the dielectric layer to the line width of the target pattern is less than the preset threshold, the number of first sublayers is 1.

13. The mask according to claim 12, wherein the dielectric layer is further formed with a marker for positioning cutting, and the marker is configured to determine a first target area on the first sublayer for forming the first pattern and a second target area on the second sublayer for forming the target pattern.

14. The mask according to claim 13, wherein the first pattern is formed by using the patterning apparatus to cut the first target area in a direction of a thickness of the first sublayer; and the target pattern is formed by using the patterning apparatus to cut the second target area in a direction of the thickness of the second sublayer.

15. The mask according to any one of claims 11-14, wherein the mask further comprises a substrate and an insulating layer formed between the substrate and the dielectric layer.

16. The mask according to claim 15, wherein the substrate is a silicon substrate, the dielectric layer is a silicon dielectric layer, and the insulating layer is a silicon dioxide insulating layer.

17. The mask according to claim 15, wherein thicknesses of the insulating layer, the dielectric layer, and the substrate increase sequentially.

18. The mask according to claim 12, wherein the preset threshold is 5.

19. The mask according to claim 18, wherein the patterning apparatus is a focused ion beam apparatus, and the cutting depth-to-width ratio is 1:1.

20. A Josephson junction element fabricated by masking based on the mask according to any one of claims 11-19, wherein the line width of the target pattern is between 150 nm and 250 nm.

21. A superconducting quantum chip comprising the Josephson junction element according to claim 20.
